(19) **Europäisches Patentamt**
**European Patent Office**
**Office européen des brevets**

(11) **EP 1 112 025 B1**

(12) **EUROPEAN PATENT SPECIFICATION**

(45) Date of publication and mention
of the grant of the patent:
**03.11.2010 Bulletin 2010/44**

(51) Int Cl.:
***G01R 33/28*** (2006.01)

(21) Application number: **99945468.9**

(22) Date of filing: **03.09.1999**

(86) International application number:
**PCT/US1999/020216**

(87) International publication number:
**WO 2000/013586 (16.03.2000 Gazette 2000/11)**

(54) **METHOD AND APPARATUS TO ESTIMATE LOCATION AND ORIENTATION OF OBJECTS DURING MAGNETIC RESONANCE IMAGING**

VERFAHREN UND VORRICHTUNG ZUR ABSCHÄTZUNG DES ORTES UND DER ORIENTATION VON OBJEKTEN WÄHREND KERNMAGNETRESONANZBILDGEBUNG

PROCEDE ET APPAREIL SERVANT A EVALUER L'EMPLACEMENT ET L'ORIENTATION D'OBJETS AU COURS D'UNE IMAGERIE PAR RESONANCE MAGNETIQUE

(84) Designated Contracting States:
**DE ES FR GB IT NL**

(72) Inventor: **NEVO, Erez**
**42756 Natania (IL)**

(30) Priority: **08.09.1998 US 99498 P**
**03.11.1998 US 106831 P**
**20.07.1999 US 144774 P**

(74) Representative: **Machtalère, Georges et al**
**Dennemeyer & Associates S.A.**
**55, rue des Bruyères**
**1274 Howald (LU)**

(43) Date of publication of application:
**04.07.2001 Bulletin 2001/27**

(56) References cited:
**WO-A-94/04938       US-A- 5 099 845**
**US-A- 5 307 808       US-A- 5 318 025**
**US-A- 5 425 367       US-A- 5 558 091**
**US-A- 5 727 553       US-A- 5 913 820**

(73) Proprietor: **Robin Medical Inc.**
**Baltimore, MD 21208 (US)**

## Description

### Field of the Invention

The invention relates to methodology and apparatus to determine the location and orientation of an object, for example a medical device, located inside or outside a body, while the body is being scanned by magnetic resonance imaging (MRI). More specifically, the invention enables estimation of the location and orientation of various devices(e.g. catheters, surgery instruments, biopsy needles, etc.) by measuring voltages induced by time-variable magnetic fields in a set of miniature coils. Such time-variable magnetic fields are generated by an MRI scanner during its normal operation.

### Background of the Invention

Minimally invasive procedures: Minimally-invasive diagnostic or interventional procedures require either direct visual viewing or indirect imaging of the field of operation and determination of the location and orientation of the operational device. For example, laparoscopic interventions are controlled by direct viewing of the operational field with rigid endoscopes, while flexible endoscopes are commonly used for diagnostic and interventional procedures within the gastro-intestinal tract. Vascular catheters are manipulated and manoeuvred by the operator, with real-time X-ray imaging to present the catheter location and orientation. Ultrasound imaging and new real-time MRI and CT scanners are used to guide diagnostic procedures (e.g. aspiration and biopsy) and therapeutic interventions (e.g. ablation, local drug delivery) with deep targets. While the previous examples provide either direct (optical) or indirect (imaging) view of the operation field and the device, another approach is based on remote sensing of the device with mechanical, optical or electromagnetic means to determine the location and orientation of the device inside the body.

Stereotaxis: Computer-assisted stereotaxis is a valuable technique for performing diagnostic and interventional procedures, most typically with the brain. The concept behind the technique is to have real-time measurement of the device location in the same coordinate system as an image of the field of operation. The current location of the device and its future path are presented in real-time on the image and provide the operator with feed-back to manipulate the device with minimal damage to the organs. During traditional stereotaxis the patient wears a special halo-like headframe, which provides the common coordinate system, and CT or MRI scans are performed to create a three-dimensional computer image that provides the exact location of the target (e.g. tumour) in relation to the headframe. The device is mechanically attached to the frame and sensors provide its location in relation to the head frame. When this technique is used for biopsy or minimally-invasive surgery of the brain, it guides the surgeon in determining where to make a small hole in the skull to reach the target. Newer technology is the frameless technique, using a navigational wand without the headframe (e.g. Nitin Patel and David Sandeman, "A Simple Trajectory Guidance Device that Assists Freehand and Interactive Image Guided Biopsy of Small Deep Intracranial Targets", Comp Aid Surg 2:186-192, 1997). In this technique remote sensing system (e.g. light sources and sensors) provides the real-time location of the device with respect to the image coordinate system. Yet both the stereotaxis and the frameless techniques are typically limited to the use of rigid devices like needles or biopsy forceps since their adequate operation requires either mechanical attachments or line of sight between the light sources and the sensors.

Electromagnetic remote sensing: Newer remote sensing techniques are based on electromagnetism. For example, the Bladen and Anderson technique (WO 94/04938) is an active electromagnetic tracking methodology that requires the use of electromagnetic field generator or generators to determine the location and orientation of a sensor (Page 3 lines 17-36; Page 4 line 24 through Page 5 line 9) . This methodology cannot be directly used during MRI because the application of an external electromagnetic field creates an unacceptable level of image artifacts. These artifacts can be avoided by interleaving the tracking step with the image acquisition step, which requires a modification of the MRI pulse sequences and lengthen the imaging time. It also requires mechanical modification of the scanner, to add the field generators into the structure of the scanner. The addition of conducting elements to the scanner (the coils of the generators) may result with substantial artifacts due to the creation of eddy currents and may create electromagnetic interference with the scanner.

Acker et al (US Patent 5,558,091) disclose such a method and apparatus to determine the position and orientation of a device inside the body. This method uses magnetic fields generated by Helmholtz coils, and a set of orthogonal sensors to measure components of these fields and to determine the position and orientation from these measurements. The measurement of the magnetic field components is based on Hall effect and requires exciting currents in the sensors in order to generate the measured signals. The technique requires control of the external magnetic fields and either steady-state or oscillating fields, for the induced voltages to reach a state of equilibrium. These requirements prevent, or greatly complicate, the use of this technique with magnetic fields generated by the MRI system, and requires the addition of a dedicated set of coils to generate the required magnetic fields.

A different approach for remote sensing of location is disclosed by Pfeiler et al. (US Patent 5,042,486) and is further used by Ben-Haim for intra-body mapping (US Patent 5,391,199). Their technology is based on generating weak radio-frequency (RF) signals from three different transmitters, receiving the signals through an RF antenna inside the device, and calculating the distances from the transmitters, which define the spatial location of the device. As with the previous methodology, the application of the technology to MRI is problematic due to the simultaneous use of RF signals by the MR scanning. Potential difficulties are the heating of the receiving antenna in the device by the high amplitude excitation RF transmissions of the MRI scanner and artifacts in the MR image.

Dumoulin and colleagues disclose another approach to determine the location of a device, using a small receiving coil which is sensitive to near-neighbourhood emitted RF signal during the MR imaging process (Dumoulin CL, Darro RD, Souza SP, "Magnetic resonance tracking", in Interventional MR, edited by Jolesz FA and Young IY, Mosby, 1998; US -A- 5,318,025). In US-A-5,318,025, there is described a method of determining the instantaneous location and orientation of an object moving through a three-dimensional space within the imaging space of magnetic resonance imaging apparatus according to the preamble of claim 1.

An apparatus for determining the instantaneous location and orientation of an object moving through a three-dimensional space within the imaging space of magnetic resonance imaging apparatus , according to the preamble of claim 6 is also known from US-A-5,318,025.

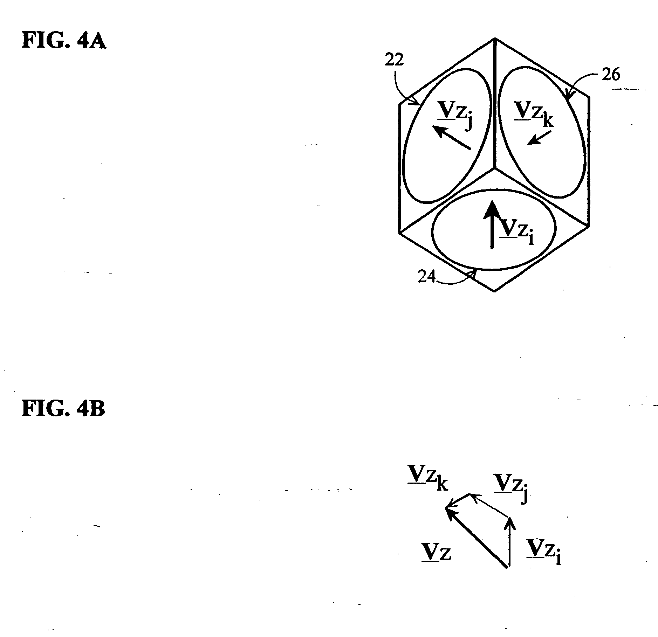

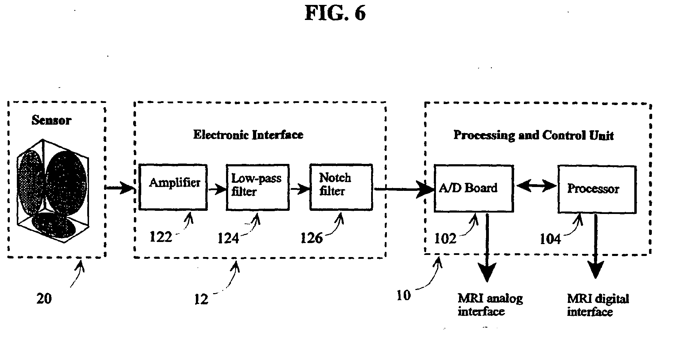

This US -A- 5,318,025 (Dumoulin and colleagues) teaches a tracking system based on induction of signals in receiving coils by the radio-frequency (RF) emission from the tissue near the device (Column 4, lines 33-50). It requires the use of all the components of an MRI scanner, including a high-intensity homogenous magnetic field, a set of three orthogonal magnetic gradient fields, RF transmission system, an RF receiving system, in addition to its own processing and controlling modules (Figure 6 and Column 6, line 44 through Column 7, line 2). Since it is based on the same mechanism as that of image acquisition by MRI scanner, it can be viewed as imaging of a very small region of interest. Consequently, it requires the presence of material that can generate MR signals in the vicinity of the RF coils, either tissue (if the sensor is inside the body, like in catheters) or a small chamber of contrast agent (if tracking is done outside the body). Furthermore, the Dumoulin system requires the modification of the normal sequence of image acquisition by the use of special pulse sequences which enable the tracking (Figure 4 and Column 4). This substantially complicates the programming of the pulse sequence of the scanner (due to the effect of additional RF and gradient activations for tracking on the imaging components of the sequence), lengthens the time of scan, and limits the update rate of tracking additional limitations of this tracking technique include the potential heating of the RF coils, especially inside the body; and indirect determination of the orientation from the estimated location of at least 2 separate RF coils, with limited accuracy when the sensor size is limited (i.e. when the distance between the two coils is short).

Moreover, WO 94/04938 A1 discloses a method and an apparatus for determining the orientation and location of an object involving providing a coil assembly including a plurality of at least three mutually orthogonal sensor coils, attaching the sensor coils to the object, measuring electrical potentials induced in said sensor coils by activation of magnetic field generating coils and computing the orientation and location of the object from the measured electrical potentials.

Interventional MRI: Many of the advantages of MRI that make it a powerful clinical imaging tool are also valuable during interventional procedures. The lack of ionizing radiation and the oblique and multi-planar imaging capabilities are particularly useful during invasive procedures. The absence of beam-hardening artifacts from bone allows complex approaches to anatomic regions that may be difficult or impossible with other imaging techniques such as conventional CT. Perhaps the greatest advantage of MRI is the superior soft-tissue contrast resolution, which allows early and sensitive detection of tissue changes during interventional procedures. Many experts now consider MRI to be one of the most powerful imaging techniques to guide interventional interstitial procedures, and in some cases even endovascular or endoluminal procedures (Yoshimi Anzai, Rex Hamilton, Shantanu Sinha, Antonio DeSalles, Keith Black, Robert Lufkin, "Interventional MRI for Head and Neck Cancer and Other Applications", Advances in Oncology, May 1995, Vol 11 No. 2).

From the presented background on current methodologies, one can define the ideal system for minimal invasive procedures: It should provide real-time, 3-dimensional, non-ionizing imaging (like MRI or ultrasound) as feed-back to the user for optimal insertion and intervention; it should implement flexible, miniaturized devices which are remotely sensed to provide their location and orientation. By combining a composite image of the field of operation and the device location and orientation, the operator can navigate and manipulate the device without direct vision of the field of operation and the device. This may facilitate the use of minimal invasive intervention in the brain or other organs.

## Objects and Summary of the Invention

An object of the present invention is to provide a novel method and apparatus for determining the instantaneous location and orientation of an object moving through a three-dimensional space, which method and apparatus have advantages in one or more of the above respects.

Another object of the present invention is to provide such a method and apparatus which is particularly useful in MRI systems by making use of a basic universal component of the MRI system, namely the time-varying magnetic gradients which are typically generated by a set of three orthogonal electromagnetic coils in such systems.

To achieve this, the method of the invention is characterized by the features claimed in the characterizing part of claim 1 and the invention provides an apparatus according to the characterizing part of claim 6.

According to one aspect of the present invention, there is provided a method of determining the instantaneous location and orientation of an object moving through a three-dimensional space within the imaging space of magnetic resonance imaging apparatus during operation of a magnetic resonance imaging apparatus, comprising:

providing a coil assembly including a plurality of at least three sensor coils having axes of known orientation with respect to each other, said axes being mutually orthogonal with respect to one another, the coil assembly being attached to or integrated into said object, measuring the instantaneous values of electrical potentials induced in said plurality of sensor coils by the activation of the gradient coils of said magnetic resonance imaging apparatus during operation of said magnetic resonance imaging apparatus; and computing the instantaneous location and orientation of said object within said space by comparing said measured instantaneous values of electrical potentials with the known three dimensional maps of the magnitude and the direction of the magnetic fields generated within said imaging space by said activation of the gradient coils, said step of comparing making use of the known relative orientation of said plurality of sensor coils.

According to further features in the described preferred embodiment, the magnetic field gradient is generated by activating three orthogonally disposed pairs of gradient coils according to a predetermined activating pattern; and the measured instantaneous values of the induces electrical potentials generated in the sensor coils are processed, together with the predetermined activating pattern of the gradient coils and the known relative orientation of the sensor coils, to provide an estimate of the location and orientation of the object.

According to another aspect of the present invention, there is provided apparatus for determining the instantaneous location and orientation of an object moving through a three-dimensioned space within the imaging space of magnetic resonance imaging apparatus during operation of the magnetic resonance imaging apparatus, comprising: a coil assembly including a plurality of at least three sensor coils having axes of known orientation with respect to each other, said axes being mutually orthogonal with respect to one another, the coil assembly being attached to or integrated into said object, means for measuring the instantaneous values of electrical potentials induced in said plurality of sensor coils by activation of the gradient coils of said magnetic resonance imaging apparatus during operation of said magnetic resonance imaging apparatus; and a processor for computing the instantaneous location and orientation of said object within said space by comparing said measured instantaneous values of electrical potentials with the known three dimensional maps of the magnitude and the direction of the magnetic filed generated within said imaging space by said activation of the gradient coils, said comparing making use of the known relative orientation of said plurality of sensor coils.

The disclosed methodology and apparatus enable the estimation of the location and orientation of an object or a device by using a set of miniature, orthogonal coils. The simplest embodiment has a set of three orthogonal coils.

However more complex coils sets, for example a set of three orthogonal pairs of parallel coils, can improve the accuracy of the tracking with a higher cost of the system. To simplify the presentation, the following disclosure deals specifically with a set of three orthogonal coils, and also refers to the more complex configuration of three orthogonal pairs of coils. However the same concepts can be applied to various combinations of coils by anyone familiar with the field of the invention.

The time change of magnetic flux through a coil induces electromotive force (i.e. electric potential) across the coil (Faraday Law of electromagnetism). MRI scanners generate time-variable magnetic fields to create magnetic gradients in the scanned volume. By measuring the induced electric potentials in the three orthogonal coils (or pairs of coils), and by getting the time pattern of the generated magnetic gradients as input from the MRI scanner, both the location and orientation of the device can be estimated.

The present invention has significant advantages over existing methodologies. Compared with stereotaxis, either the frame or frameless techniques, the new methodology enables the use of devices like catheters or surgical instrumentation without the need for direct line of sight with the device. Unlike the remote electromagnetic localization methodology of Acker et al the present invention is based on measurement of voltages induced by a set of time-varying electromagnetic gradient fields in a set of coils (Faraday Law), rather than the need to use homogenous and gradient fields which induce voltages in a set of miniature conductors carrying electrical current (Hall effect). Thus, the present invention is totally passive, it does not require any excitation of the sensors, nor the use of dedicated magnetic fields, and the requirement for time-variable magnetic fields is satisfied with virtually any MRI scanning protocol which is in routine clinical use. The methods disclosed by Pfeiler et al and Dumoulin et al require the use of two sensors to measure orientations and thus have limited accuracy of orientation estimation, while the present invention uses a sensor which provides simultaneously accurate orientation and location tracking. Unlike existing optical tracking systems, there is no limitation on the number of sensors being used, and there is no need to maintain a line of sight between the sensor and the tracking apparatus. All other tracking methodologies are based on their own reference system, and should be aligned with the MRI coordinate system by a time-consuming registration procedure. The disclosed tracking methodology does not require registration since it uses the same set of gradient coils which are used by the MRI scanner for spatial encoding of the images.

## Brief Description of the Drawings

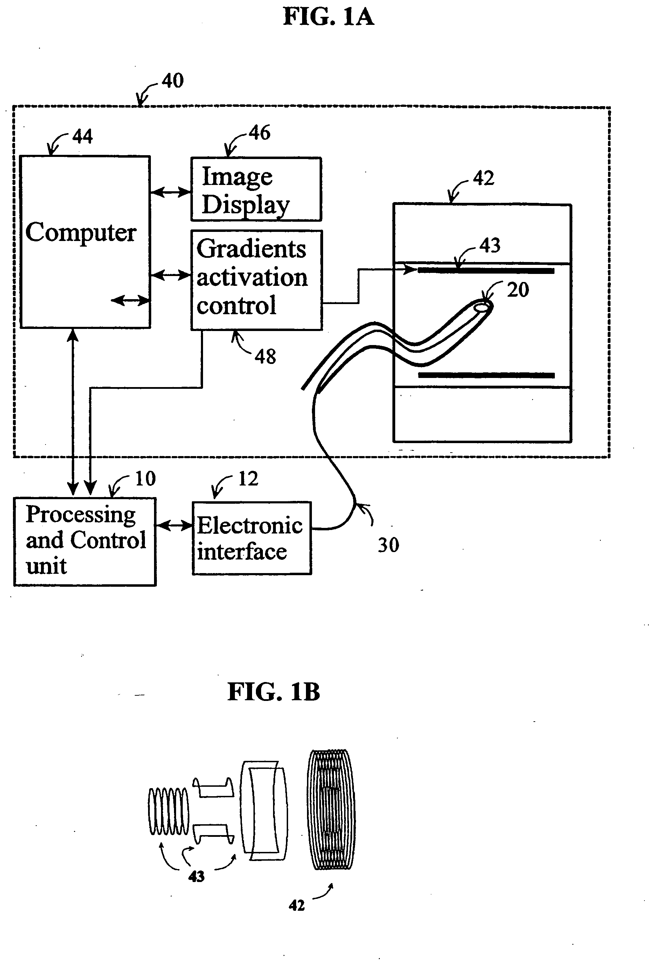

Figure 1A provides a block diagram description of the invented apparatus which includes a processing and control unit (10), a sensor (20), the module is integrated into or attached to an object or a device (30), electronic interface (12), and MRI system (40) with its main coil (42), three gradient coils (43), computer (44), gradient coils control unit (48), and image display (46). The MRI coils (42 and 43) are presented in more details in Figure 1B with the different coils displaced along the MRI main axis to clarify the presentation.

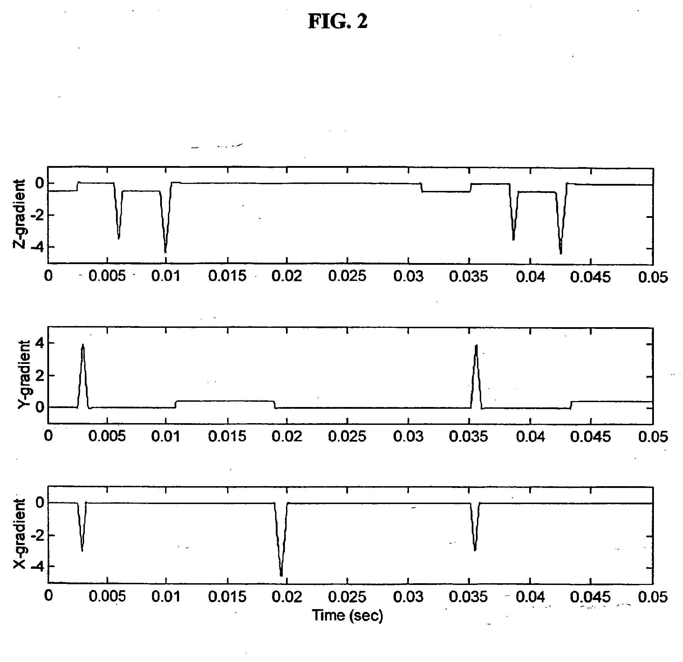

Figure 2 presents the activation sequence of the MRI gradient coils as functions of time during a standard spin echo scan. The steep rise and drop of the generated magnetic fields result with high rate of change of the magnetic flux through the coils.

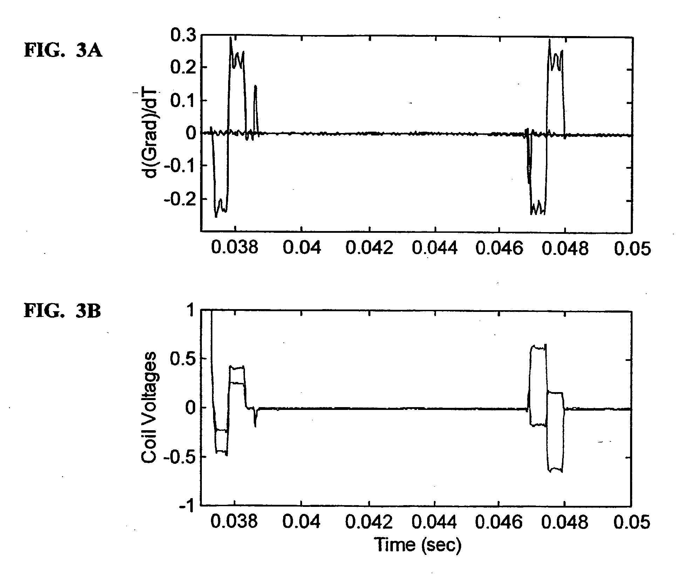

Figure 3A presents the time-derivative of the magnetic fields of the MRI gradient coils (which are presented in Figure 2) as functions of time. Figure 3B presents the voltages induced by the time-varying magnetic fields of the MRI gradient coils (those presented in Figure 2 and 3A) in two orthogonal sensing coils (e.g. 22, 24) as functions of time.

Figure 4A provides a schematic configuration of three orthogonal coils (22, 24, 26) in the sensor (20) and the induced voltages in each coil. Figure 4B presents an example of the vectorial summation of the voltages induced in each coil during activation of the magnetic field of the Z-gradient coil into a voltage vector termed $\underline{Vz}$.

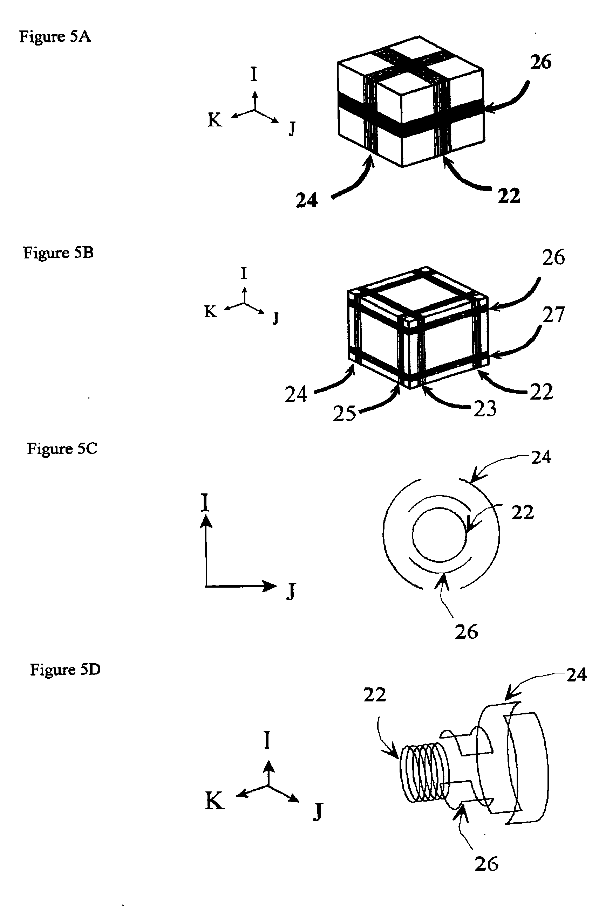

Figures 5A-5D illustrate three potential configurations of coils which provide a set of three orthogonal coils or pairs of coils. Figure 5A shows a cubic configuration for extra-corporeal applications with three orthogonal coils having a typical size of up to 10 mm. Figure 5B shows a cubic configuration with 3 orthogonal *pairs* of parallel coils. Figures 5C-5D show a cylindrical configuration for use with catheters with a typical diameter of 2-3 mm. Figure 5C illustrates an axial (along the K axis) view, while Figure 5D shows a 3-dimensional display of the sensor, having one cylindrical coil (22) and two pairs of transverse "saddle" coils (24, 26).

Figure 6 presents a block diagram of the measurement and processing system, including the sensor (20), the electronic interface (12) and the processing and control unit (10).

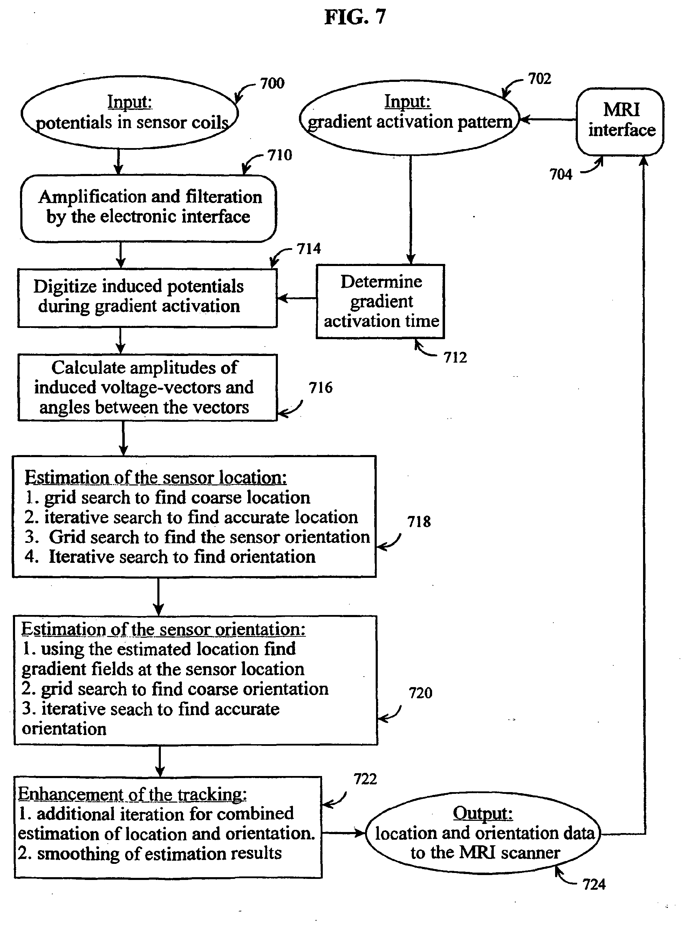

Figure 7 presents a block diagram of the preferred embodiment of the tracking methodology for various clinical uses.

## Detailed Description of the Preferred Embodiment

Referring now to Figure 1, a typical MRI system (40) has several modules which are specifically relevant to the current invention: the three gradient coils (43), the gradient coils control unit (48), and the image display (46). The exact implementation of the invented methodology depends on the MRI mode of imaging, and the following presentation relates, as a typical example, to a standard MRI spin-echo imaging mode. During the spin-echo protocol, repeated generation of magnetic fields by the 3 gradient coils provide the spatial encoding of the received MR echo and enable the reconstruction of the image. A sample sequence is given in Figure 2 (recorded from a Signa MRI system, General Electric, USA). For this sequence the system activates the Z-gradient coil for "slice selection", simultaneously the X and Y gradient coils for "phase encoding" and the X gradient coil for the "read out" phase.

The gradient control unit (48) provides the processing unit (10) with real-time presentation of the activation sequence of the three gradient coils which generate the magnetic gradients (Figure 2). The magnetic fields which are generated by the gradient coils have components in all three axes (X,Y,Z), but each of the coils has a precise linear change of the amplitude of the Z-component along one axis only, where these coils and the generated magnetic gradients are termed by this specific axis (i.e. for the Z-gradient (Gz) the Z-component varies linearly with the Z-coordinate, for the X-gradient (Gx) the Z-component varies linearly with the X-coordinate, and for the Y-gradient (Gy) the Z-component varies linearly with the Y-coordinate). The other components of the magnetic fields of the gradient coils have a specific spatial distribution which depends on the specific design of the gradient coils. A full description of the magnetic field as function of time and location with any mode of operation (G(t,x,y,z)) can be calculated within the processing unit (10) by vectorial summation of the three time-variable magnetic fields of the gradient coils and the time-invariant main field (Bo) of the MRI scanner (in the following presentation vectors are underlined, to distinguish from scalars):

$$(1) \qquad \underline{G}(t,x,y,z) = \underline{Gx}(t,x,y,z) + \underline{Gy}(t,x,y,z) + \underline{Gz}(t,x,y,z) + \underline{Bo}(x,y,z)$$

where x,y,z are coordinates along the three axes of the MRI coordinate system (X, Y, Z, respectively) and t is a time variable. Additional magnetic fields, which are generated by the RF (radio frequency) coils of the MRI, are not being used by the current invention. These fields, which alternate in the range of mega-hertz, induce high-frequency electrical potentials in the sensing coils which can be removed by low-pass filtration.

In one preferred embodiment (Figure 4A), the sensor (20) consists of a set of three orthogonal sensing coils (22, 24, 26). The time varying magnetic field $\underline{G}(t,x,y,z)$ induces electric potential, or voltage (V), in each of the sensing coils, and the magnitude of the induced voltage is related to the time-derivative of the magnetic flux $\Theta$ through the coil, as given by Faraday Law:

$$(2) \qquad V = -d\Theta/dt$$

the magnetic flux at each location is determined by the magnetic field $\underline{G}(t,x,y,z)$, the coil area (A), and the direction of the magnetic field with respect to the spatial orientation of the coil, as defined by a unit vector $\underline{n}$ vertical to the plane of the coil:

$$(3) \qquad \Theta = \underline{G}(t) \cdot \underline{n} \, A$$

where the dot denotes a vectorial dot product.

Combining equations 1 - 3, the induced voltages in the coils are directly related to the time derivative of the magnetic field:

$$(4) \qquad V = -d \left[ \, (\underline{Gx}(t,x,y,z) + \underline{Gy}(t,x,y,z) + \underline{Gz}(t,x,y,z) + \underline{Bo}(x,y,z)) \cdot \underline{n} \, A \, \right] /dt$$

If the sensor does not move or rotate, the Bo field and the direction vector $\underline{n}$ are constant and the induced voltage in each coil is given by:

$$(5) \qquad V = -d \left[ (\underline{Gx}(t,x,y,z) + \underline{Gy}(t,x,y,z) + \underline{Gz}(t,x,y,z)) \right] /dt \cdot \underline{n} \, A$$

The measured magnitudes of the induced voltages at the three coils and the known magnetic field $\underline{G}(t,x,y,z)$ as function of time at each point in the operating field (as calculated by summing the individual magnetic fields of all gradient coils which are active at a specific time) enable the estimation of the object location and direction by the following sequence of steps. This sequence of steps is only one option out of several possible approaches which are similar in concept and only differ in the actual embodiment of the estimation process.

### Step 1. Measurement of induced voltages

The induced voltages in the three orthogonal coils (Figure 4) enable the calculation of the magnetic fields of the gradient coils at the location of the sensor without knowing the orientation of the sensor. While the magnitudes of the induced voltages at each coil change with the orientation, their vectorial sum is independent of the orientation and is proportional to the time-derivative of the magnetic field at the location of the sensor, as given by equations 4 and 5. For example, during activation of the Z-gradient, the time-varying magnetic field induces three voltages in the three coils. For a configuration with three orthogonal pairs of parallel coils (Figure 5B), the induced voltages in two parallel coils of each pair are averaged and the results are analyzed similarly as with three single coils.

Thus during activation of the Z-gradient the three voltages $Vz_i$, $Vz_j$, $Vz_k$ correspond either to the measured voltages in the three single coils or are the averages of the measured voltages in each of the three pairs of coils. We define the induced voltages as vectors $\underline{Vz}_i$, $\underline{Vz}_j$, $\underline{Vz}_k$ with magnitudes equal to the induced voltages in each coil and directions defined by unit vectors vertical to the corresponding coil plane (Figure 4A). The vectorial sum of the three vectors, denoted $\underline{Vz}$, is in the direction of the time-derivative of the local magnetic field of the Z-gradient:

$$(6) \quad \underline{Vz} = -[d(\underline{Gz}(t,x,y,z))/dt \bullet \underline{n}_i \ A] \ \underline{n}_i - [d(\underline{Gz}(t,x,y,z))/dt \bullet \underline{n}_j \ A] \ \underline{n}_j - [d(\underline{Gz}(t,x,y,z))/dt \bullet \underline{n}_k \ A] \ \underline{n}_k$$

This can be easily demonstrated if we break the time derivative of the magnetic field vector ($\underline{dG}(t)/dt$) into three orthogonal components which are in the directions of three orthogonal coils. Since components parallel to the plane of each coil do not induce any voltage, the induced voltages $\underline{Viz}_i$, $\underline{Vz}_j$, $\underline{Vz}_k$ are proportional to the three components of the time derivative of the magnetic field and their sum is in the same direction as the time derivative of the magnetic field ($\underline{dG}(t)/dt$).

Finally, the magnitude of the voltage vector is proportional to the magnitude of the time-derivative of the magnetic field of the Z-gradient at the location of the coils and at the time of measurement (Figure 4B):

$$(7) \quad |\underline{Vz}| = | \ (d(\underline{Gz}(t,x,y,z))/dt) \ A \ |$$

The magnitudes and directions of the time-derivative of the local magnetic fields of the X and Y gradients, or of any combination of two or three magnetic fields of different gradient coils, are related (i.e. have the same direction and proportional magnitude) to the vectorial sum of the induced voltages in the three coils, as described above for the Z-gradient.

The proportionality coefficient of the relation between the magnetic field and the induced voltage in a coil is determined by the geometry of the coils, i.e. by A, the total area of the coil (if a coil with multiple loops is used the total area is the sum of all areas of the individual loops).

During a typical sequence of MRI scanning two or even all the three gradient coils can be activated at the same time. The magnetic fields of the gradient coils are known for a specific MRI scanner by simulation, based on the known geometry of the gradient coils, or by measurement of the fields as function of location during activation of each gradient coil. The activation sequences of each gradient coil as function of time are provided by the MRI scanner as analog signals (Figure 2) or digital data. The known magnetic field and the activation sequence of a specific gradient coil can be used to calculate the magnetic field at each spatial location and for a specific time point, or to calculate the time derivative of the magnetic field by analog or numerical differentiation (Figure 3A). This information can also be used to separate magnetic fields which are generated by simultaneously activated two or three gradient coils. For example, in Figure 2 the Z-gradient coil is activated alone, while the X-gradient coil is activated alone or together with the Y-gradient coil. The magnitude and orientation of the magnetic field of the X-gradient coil can be determined from its independent activation, and this information can be used to eliminate the contribution of the magnetic field of the X-gradient coil from the induced voltages measured during simultaneous activation of the X and Y gradient coils and to extract the magnitude and orientation of the magnetic field of the Y-gradient coil.

An alternative, more general approach is to reconstruct the reference magnetic fields, which are used in the estimation process (as detailed below), as a superposition of the simultaneously activated magnetic fields of different gradients. Thus for each time point, the activation sequences of the coils are used to determine the active fields and their magnitude at that time, and the overall field is calculated by adding the field contributions from all active coils, as shown is Equations 4 and 5. The location of the device is estimated by comparing the measured voltages (during simultaneous activation of more than one gradient) to time derivative of the reference, composite magnetic field.

***Step 2: Transformation from measured voltages to magnetic fields***

The measured voltages are proportional to the time-derivative of the magnetic fields, and the proportionality coefficient is determined by the properties of the sensing coils (i.e. the area of each loop and the number of loops). As explained above, the time-derivative of the magnetic field is at the same direction as of the voltage vector (e.g. $\underline{Vz}$ for Z-gradient) and its magnitude can be calculated by re-arranging equation (7):

$$(8) \qquad |\,d(\underline{Gz}(t,x,y,z))/dt\,| = |\,\underline{Vz}\,|\,/\,A$$

Modem MRI scanners use crushers in association with each activation of a gradient. Typically, the crushers are spike-like rapid activation and deactivation of the gradient coil. For example, in a General Electric Signa MRI scanner these crushers follow the shape of a triangle (Figure 2) or trapezoid, and their time-derivative is similar to a positive pulse function (the up-slope of the crusher) and a negative pulse function (the down-slope of the crusher) (Figure 3A). The induced voltages are linearly related to the time derivative of the gradient field (Equations 4 and 5) and follow the same pattern (Figure 3B). For linear activation and de-activation of the gradients, the induced voltages during each constant phase (i.e. up-slope and down-slope) can be averaged to yield a value which is directly used to calculate the amplitude of the time-derivative of the magnetic field by equation 8. Furthermore, by measuring the time of activation or de-activation of the gradients (e.g. $\Delta t$), the amplitude of the actual magnetic field can be calculated by (for linear activation and deactivation patterns):

$$(9) \qquad \underline{Gz}(t,x,y,z) = d(\underline{Gz}(t,x,y,z))/dt \ast \Delta t$$

In the following presentation the determination of the location and orientation is based on using the magnetic field rather than their respective time-derivative. This is possible if the slope of the gradient activation pattern is linear and known, yet a similar procedure can be implemented by using the time derivatives of the magnetic fields. The magnetic fields are provided by a set of 3-dimensional maps, for example by using Cartesian coordinate system with X,Y,Z coordinates. For each location, the magnetic field vector can be mapped as a set of magnitude and direction descriptors (e.g. two angles in a spherical coordinate system), or as a set of three orthogonal components of the field vector.

### Step 3: Estimation of the location x,y,z of the device in the MRI coordinate system

By knowing the 3-dimensional distributions of the magnetic fields of the X,Y and Z gradients (or a combination of 2 or 3 gradient fields), the instantaneous location of the device can be estimated. A search algorithm finds a specific location which, during the activation of the gradients, has magnetic fields with similar magnitudes as those calculated from the measured coil voltages. A typical search algorithm minimizes a cost function which is based on the level of similarity between the estimated fields and the reference known fields at the assumed location, for example a least squares cost function is the sum of the squares of the differences between each of the estimated magnetic fields and the corresponding reference fields at the current estimated location.

Several problems can hamper the accuracy of the estimation - the search algorithm may find a local minima of the cost function (i.e. a wrong solution), the cost function may be flat or noisy at the region of the minima which may result in a non-accurate solution, and the minimized function may have more than one solution (non-unique solution).

The problem of local minima can be solved by using search algorithms which guarantee the convergence to the true, global minima. For example, a grid search evaluates the cost function all over the potential range of solutions. For the current invention, a grid-search which evaluates the cost function at all combinations of x,y,z coordinates at a resolution of 1 cm was found to guarantee convergence to the global minima.

The accuracy of the estimation critically depends on the signal-to-noise ratio of the measurements. When only few measurements are used, for example in our case three unknown location variables are calculated from only three measurements (the amplitudes of the three voltage vectors), any noise will bias the estimation results. The effect of noise can be reduced when more measurements are used and a least-squares estimation algorithm is applied. This can be achieved by using more coils, for example a set of six coils, arranged as three orthogonal parallel pairs with known distances between the parallel coils. Obviously, more coils will generate more data with a high cost of more complex processing apparatus.

The problem of non-uniqueness of the solution is associated with multiple minima, for example due to symmetry in the cost function. The typical spatial distribution of the gradient fields in commercial MRI systems has symmetry in the three axes, and as a result up to eight equivalent minima may exist on the cost function with up to eight different solutions for the estimation process. Multiple solutions are a major limitation for any tracking method, and additional data must be used to reduce the number of solutions.

***Step 4: Calculation of angles between the voltage vectors***

The magnetic fields are vectors, and at each point of the imaging field the orientations of the magnetic fields of the three gradients are typically different, and can be used as additional information for the estimation process. Since the orientation of the device relatively to the MRI coordinate system is still unknown at this stage of the estimation process, the angles between the three gradient vectors are used instead of the global orientations of the vectors with respect to the MRI scanner coordinate system. The angle between any two vectors can be determined by vector algebra and analytic geometry. For example, the angle $\alpha$ between the voltage vector $\underline{Vz}$, which is induced by the Z-gradient, and the voltage vector $\underline{Vx}$, which is induced by the X-gradient, is determined by calculating the squared amplitude of the vectorial difference between the two vectors:

$$(10) \quad |\underline{Vz} - \underline{Vx}|^2 = (Vz_i - Vx_i)^2 + (Vz_j - Vx_j)^2 + (Vz_k - Vx_k)^2$$

where $Vz_i$, $Vz_j$, $Vz_k$ and $Vx_i$, $Vx_j$, $Vx_k$ are the measured voltages in the i,j,k coils during activation of the Z-gradient coil and the X-gradient coil, respectively, and then calculating the angle between the two vectors by applying the cosine law:

$$(11) \quad \cos(\alpha) = \left( |\underline{Vz}|^2 + |\underline{Vx}|^2 - |\underline{Vz} - \underline{Vx}|^2 \right) / \left( 2 * |\underline{Vz}| * |\underline{Vx}| \right)$$

where $|\underline{Vz}|$ and $|\underline{Vx}|$ are the magnitudes of the voltage vectors induced by the Z and X gradients, respectively.

The measured angles are compared to reference angular field maps, which can be generated from the 3-dimensional field maps of the three gradients using the same approach as described by equations 10 and 11.

In the estimation process, the measured angles are compared to the reference angles at the estimated location in addition to the comparison of the magnetic fields amplitudes. This additional information improves the accuracy of the estimation process and eliminates the problem of non-uniqueness due to symmetry of the magnetic fields in the XY-plane of the MRI gradient coils.

Using the amplitudes of the voltage vectors and the angles between the vectors, there are still two equivalent anti-symmetric solutions which have the same cost-function. The gradient fields of the MRI scanner are anti-symmetric - for example for a set of values of X,Y and Z coordinates there exists a point with the opposite X,Y and Z values (i.e. having the same absolute value but opposite signs) which has exactly the same absolute magnitudes and angles between the gradient field vectors. The distinction between the two anti-symmetric solutions can be done only during later stages of the estimation process, as explained below.

Following the grid search, a more accurate location can be found by local search around one of the two locations which were found to be the global minima of the cost-function. Since the two solutions are anti-symmetric, the local search can be applied around one of the two solutions and the final result can be used to find the anti-symmetric solution.

The local search applies a standard search algorithm, for example a Levenberg-Marquardt search algorithm, using either the six data points (three amplitudes of the voltage vectors and three angles, as detailed above), or with more data when it is available by using measurements from configuration with more than 3 coils.

***Step 5: Determination of the device orientation***

Once the spatial location of the sensor in the magnet bore is determined through steps 1-4, the X,Y,Z components of the magnetic field at this location during the operation of any gradient or gradient combination are known for a specific MRI scanner from the reference 3-dimensional magnetic field maps of the gradient coils. Using the voltages measured in each of the 3 coils during the activation of the gradients, the three rotation angles which transform from the MRI reference coordinate system to the local, device-attached coordinate system, are determined by an iterative optimization procedure. Furthermore, at this phase only one of the two anti-symmetric solutions provides a minimum of the new cost function, and a unique solution results.

An initial value of the three rotation angles is used to transform the X,Y,Z components of the magnetic fields of the three gradients into the components of the magnetic fields in the local (device) coordinate system I,J,K. According to Euler's Rotation Theorem, any spatial rotation can be described by three rotation angles, and various conventions exist for these angles. For example one convention (which is typically referred to as the Euler angles), is based on rotation around the Z axis by angle "$\phi$", followed by rotation around the new X axis by angle "$\theta$", and finally rotation around the new Y axis by angle "$\psi$". The three rotations can be described by a rotation matrix:

$$(12) \quad R = \begin{vmatrix} r_{11} & r_{12} & r_{13} \\ r_{21} & r_{22} & r_{23} \\ r_{31} & r_{32} & r_{33} \end{vmatrix}$$

where the rotation matrix terms are given by:

$$r_{11} = \cos(\psi)*\cos(\phi)-\cos(\theta)*\sin(\phi)*\sin(\psi);$$

$$r_{12} = \cos(\psi)*\sin(\phi)+\cos(\theta)*\cos(\phi)*\sin(\psi);$$

$$r_{13} = \sin(\psi)*\sin(\theta);$$

$$r_{21} = -\sin(\psi)*\cos(\phi)-\cos(\theta)*\sin(\phi)*\cos(\psi);$$

$$r_{22} = -\sin(\psi)*\sin(\phi)+\cos(\theta)*\cos(\phi)*\cos(\psi);$$

$$r_{23} = \cos(\psi)*\sin(\theta);$$

$$r_{31} = \sin(\theta)*\sin(\phi);$$

$$r_{32} = -\sin(\theta)*\cos(\phi);$$

$$r_{33} = \cos(\theta);$$

Using the rotation matrix, the magnetic field vector in the reference coordinate system of the MRI scanner (i.e. in the X,Y,Z system, with components Gx, Gy, Gz) can be presented in another, rotated coordinate system. If a local coordinate system I,J,K is attached to the device, and is rotated by the three rotation angles $\{\phi,\theta,\psi\}$ in reference to the X,Y,Z system, the three Cartesian components of the magnetic field vector in the rotated system (Gi, Gj, Gk) are found by:

$$(13) \quad \begin{vmatrix} Gi \\ Gj \\ Gk \end{vmatrix} = \begin{vmatrix} r_{11} & r_{12} & r_{13} \\ r_{21} & r_{22} & r_{23} \\ r_{31} & r_{32} & r_{33} \end{vmatrix} \cdot \begin{vmatrix} Gx \\ Gy \\ Gz \end{vmatrix}$$

The calculated components of the gradient magnetic field in the I,J,K local system can be compared with the measured components in order to determine the three unknown angles of rotation. These three unknowns can be solved from the three components of one gradient field, but the results may be biased due to noise in the measurements. Better results can be achieved by using data from more gradients. Since all the three gradient fields are activated during every MRI scanning, the preferred embodiment of solving for the three angles of rotation involves the use of nine gradient field components, including 3 components for each of the 3 gradients fields (or 18 components if a set of 6 coils is used) and an optimization algorithm, for example the least squares method which is described above, to solve for the best solution.

Unlike the situation with absolute values of the measured voltages, which results with a non-unique solution composed of the true solution and an anti-symmetric one, the use of the actual measurements in each coil during the activation of each gradient or a combination of two or three gradients provides a unique solution. The gradient field components in the two locations, which correspond to the two solutions, have the same absolute values but opposite directions, so the induced voltages in each coil have opposite signs. Although a more rigorous mathematical analysis can be used to prove the uniqueness of the solution at this phase of the estimation process, a numerical example is provided as a simple demonstration.

For a specific location (e.g. x=20.5 cm, y=10.5 cm, z=15cm) and three rotation angles (e.g. $\phi$ = -40, $\theta$ = 80, $\psi$ = 0) the induced voltages in the three orthogonal coils during activation of a X-gradient, Y-gradient and Z-gradient are given in Table 1 (units are arbitrary and the simulation is based on maps of the gradient fields of a Signa MRI scanner). For this location, the absolute values of the voltage vectors and the angles between these vectors are calculated and given in the Table. Estimation of the location, using only the amplitude of the voltage vectors, results with eight potential solutions which all have the same absolute values of the vectors. The angles between the voltage vectors are different in 6 of the 8 solutions, leaving only two equivalent solutions (the input location and the anti-symmetric solution x= - 20.5 cm, y = -10.5 cm, z = - 15cm). Comparison of the components of the voltage vectors shows that they have opposing signs in the two locations, which enables the determination of the true location of the sensor.

### Step 6: Improving the estimation accuracy by *using measurements from all coils*

Steps 1-5 described a preferred embodiment of the invention using a two-tier estimation process, the first one determines the location and the second one determines the orientation of the object or the device, when only three orthogonal coils are used or when the measurements from the two coils in each pair are simply averaged. However, when all the measurements are used in the estimation process a more accurate estimation result can be achieved.

The estimation process aims to find the 6 unknowns which fully define the spatial location and orientation of the sensor. Since the exact distance between the two coils of each pair is accurately known, the estimation process still aims to find 6 unknowns, for example the location and orientation of a set of three orthogonal coils, while the location and orientation of the second set of the three orthogonal coils can be defined with respect to the location and orientation of the first set. Thus, although we get more measurements (18 voltages for the 6 coils during operation of each of the three MRI gradient coils) we still have the same number of unknowns. A larger amount of data for the estimation process is a key for more accurate solution of the optimization process.

### The effect of voltages induced by the Bo field when the sensor moves or rotates

Equation 4 provides the general description for the induced voltages in the sensor coils, but the description above assumes no effect of the Bo field. This assumption is correct as long as the sensor does not move, or when the movements are relatively slow. Since the typical rise time of gradients in modern MRI system is 1 millisecond (Figure 2), and body or device movements are typically slower (in scale of seconds or tenth of a second), the effect of the Bo can be eliminated by appropriate high pass filtering of the signals from the sensor coils (for example a 100 Hz cut-off frequency), and the description above can be applied on the filtered signals during movements and rotations of the body organs (e.g. the head) or the device.

Yet the voltages induced in the sensor coils by the Bo magnetic field can be advantageously used to improve the tracking of the location and the orientation of the device or the object. Unlike the gradient fields which change in time, the Bo is constant and it induces electric potential in the sensor coils only when there is rotation of the coils which change the magnetic flux through the coils. Unlike equation 3 above, the time varying variable now is the direction of the coils which is given by a time variable unit vector $\underline{n}(t)$:

$$(14) \quad \Theta = \underline{G} \cdot \underline{n}(t)\, A$$

By applying low-pass filter on the sensor signals the Bo-induced voltages can be extracted and used to estimate the time change of the sensor orientation, i.e. the three angular velocities of the device or the sensor. This information can be used to improve the estimation process based on the magnetic fields of the gradients (e.g. by providing a better initial guess to the iterative estimation processes) or to enable better prediction of future location and orientation of the device or the sensor.

**Preferred Embodiment of the Sensor**

The preferred, minimal configuration of the sensor includes three coils 22, 24, 26. A potential configuration with three orthogonal coils is presented in Figure 5A. This configuration is suitable for extra-corporeal applications, for example devices for minimal invasive procedures like biopsy guns or surgery instruments. Furthermore, the inner space of the sensor can be used to contain electronic circuitry, powered by a miniature battery, for signal conditioning (e.g. filtration and amplification), signal transformation (e.g. into optical signal, or into frequency modulated (FM) signal), or for wireless transmission of the measured potentials.

A more complex configuration is presented in Figure 5B, where three paris of parallel coils 22, 23, 24, 25, 26, 27 can be used instead of three single coils, i.e., a total of 6 coils is used in a sensor. The major advantage of this configuration is a substantial increase in the accuracy of the tracking, since for each activation of any MRI gradient, six, rather than three, different potentials are induced, and a total of 18 measurements is available to estimate the 3 unknown location variables and the 3 unknown rotation angles with each cycle of scanning. Although the distance between each of the two parallel coils is small (e.g. 5-10 mm in the cubic configuration of Figure 5A and 1-2 mm in the cylindrical configuration of Figure 5C and 5D), the steep gradients used with modem MRI scanners on one hand, and the availability of the exact distance between the two parallel coils on the other hand, enable the use of this information to increase the accuracy of the tracking.

A second preferred configuration is presented in Figure 5C and D, and includes a cylindrical coil and two pairs of "saddle" coils positioned in orthogonal directions to the cylindrical coils and to each other (Figure 5C presents an axial view of the set of coils and Figure 5D presents an isometric view of the two pairs of saddle coils and an inner cylindrical coils, all three coils are axially displaced to clarify the presentation). This configuration is specifically useful for catheters tracking since it has a hollow cylindrical structure and it can be fixed on the tip of any catheter without blocking the lumen of the catheter. It can be used with stent placement apparatus, with various diagnostic catheters (e.g. for intra-cardiac electrophysiology studies) and with current or future therapeutic catheters (e.g. RF ablation, laser ablation, percutaneous transmyocardial revascularization (PMR), targeted drug delivery, local genetic substance placement, etc.).

In a variant of the cylindrical hollow configuration the two pairs of "saddle" coils are replaced by two planar coils, which may be positioned inside or outside the lumen of the cylindrical coil. Although this configuration partially blocks the catheter lumen, it is simpler to manufacture and may be useful with applications which do not require free lumen.

The sensors can be assembled from individual coils, for example by glueing 6 small flat coils on the 6 surfaces of a cube. On a catheter, one pair of coils has a cylindrical shape and can be directly wired over the shaft of the catheter, while the two other pairs have saddle shape, and can be glued around the cylindrical coils. Another potential approach for the construction of the multi-coil sensor is by using flexible printed electrical circuits, which include all the coils and are folded to achieve the 3-dimensional shape.

**Preferred Embodiment of the Tracking Apparatus**

The tracking apparatus (Figure 6) includes the sensor 20, the electronic interface 12, the processing module 10, and the interface with the MRI scanner. It can be custom-designed and built for the specific tracking application or assembled from commercially available components.

The electronic interface (12) contains a set of amplifiers (122) to amplify the low-voltage potentials which are induced in the coils (from millivolts level to volts), a set of low-pass filters (124) to eliminate the high frequency voltages which are induced by the RF transmission, having frequency range of 10-400 MHz (depending on the MRI magnet strength), and stop-band or notch filter (126) to remove potentials induced by the step-wise increase of the MRI gradients, which in a General Electric MRI scanner produce a 128KHz artifact. Various commercial systems with programable amplifier\filter combinations can be used to amplify and filter the low-voltage signals from the sensors (e.g. SCS-802, Alligator Technologies, Costa-Mesa, CA).

The processing and control unit (10) can be developed using readily available commercial hardware. For example, the measured signals from the sensor can be digitized by analog-to-digital (A/D) converter (102) using a standard data acquisition board (e.g. National Instruments, Austin, TX), and processed in real-time by a modem, high performance processor 104 (e.g. a Pentium III processor with MMX built-in DSP). Another potential solution, which provides faster estimation rates, can be based on digital signal processor (DSP) boards, having built-in or attached A/D converter having at least 6 channels (3 coil signals and 3 MRI gradient signals), high-performance DSP for iterative solution of location and orientation, sufficient memory capacity for the program and for data (e.g. the reference magnetic fields), and communication bus for interface with the host computer or directly with the MRI scanner (e.g. Blacktip-CPCI processing board and BITSI-DAQ analog input/output adapter, Bittware Research Systems, Concord, NH). The software for the DSP or the PC processor can be developed with standard programming languages, for example C++ or assembly. We have used the Matlab software development environment (The Math Works, Natick, MA) to rapidly implement the estimation process as described above.

The interface with the MRI includes two main components - a channel to transfer the real-time location and orientation of the sensor, and a channel (or channels) to transfer the activation pattern of the gradient coils from the MRI scanner to the processing module. Either digital communication channel, analog channels, or a combination of the two can be used. With the Signa MRI system, for example, the gradient activation sequence is available as standard analog output from the gradient control system, and tracking information can be received by the MRI through a standard serial communication line.

The overall operation of the tracking system is presented below and in Figure 7. The induced potentials in the sensors (700), typically having a magnitude of millivolts, are amplified and filtered by the electronic interface module (710). The activation pattern from the MRI scanner (702) is transferred to the tracking system through the MRI interface module (704) and may be processed by the electronic interface module (e.g. filtered) before it is digitized by the processing module. The activation pattern of the MRI gradients (Figure 2) is analyzed by the processor to determine the activation of each of the gradient coils, e.g. by threshold triggering (712). Typically we will use the crushers which have longer activation times and higher amplitude of magnetic fields. Once an activation of any gradient coil is detected, the processor digitizes the signal from the coils and processes it to determine the level of the induced signals (714). If the activation of the gradient is linear, its time-derivative during the activation is flat (Figure 3A) and the induced potential in the sensor coils is also flat (Figure 3B). Thus, the measured signals can be averaged as long as the gradient activation is on. It should be noted, however, that non-linear activation patterns can be used as long as a description of the activation pattern of the gradient coils is available. The measured signals from the three orthogonal coils are calibrated into magnetic fields units using the calibration factors of the coils (Equations 8 and 9). The measured induced voltages in the set of orthogonal coils are used to calculate the amplitude of the voltage-vector (Equations 6-7) and the angles between the voltage-vectors of the different MRI gradients (Equations 10-11) (716). These amplitudes and angles are used to estimate the location of the sensor in the MRI coordinate system (block 718, 3) and to estimate the orientation of the sensor (block 720, 4). The estimated location and orientation may be further processed to improve the quality of the tracking, e.g. by the application of a low-pass digital filter on the estimations at a specific time, using previous estimations, and may be transformed into a data format which is required by the MRI scanner (722). Finally, the tracking data (724) is transferred to the MRI scanner through the MRI interface module (704).

**Clinical Applications**

The determined location and orientation of the sensor can be transferred to the MRI scanner in real-time and used for various tasks, for example for real-time control of the scanning plane, to display the location and orientation of the object or the device with the tracking sensor on the MR image, to correct motion artifacts. Potential clinical applications of the invention can be divided into applications for diagnostic MR imaging and for interventional MRI.

Diagnostic MRI: A major problem with MR imaging is motion artifacts due to patient movement. With high-resolution scanning, which may require image acquisition during many seconds and even minutes, patient movement and breathing may induce motion artifacts and blurred images. MR scanning is specifically sensitive to movements during phase contrast angiography, diffusion imaging, and functional MRI with echo-planar imaging (EPI). Using the present invention for real-time determination of the location and orientation of the scanned object can reduce the effect of motion on the MR scans by real-time control and correction of the scanning plane, in order to compensate for the movement, or by post-acquisition image processing.

Interventional MRI: The sensor can be used with various devices, like miniature tools for minimally invasive surgery, catheters inside blood vessels, rigid and flexible endoscopes, biopsy and aspiration needles. It can be used to measure the location of the device with respect to the MRI coordinate system and to enable the MR scanner to present the device location on the MR images, as visual feedback to the operator, or to calculate and display the line of current orientation to assist the operator to steer the device into a specific target. Another potential application is to slave the MRI plane of imaging to the tracking sensor, for example to apply high resolution imaging on a small volume around the site of a catheter, for better imaging of the region of interest to improve diagnostic performance or to control the effect of an intervention (e.g radio-frequency, cryo, or chemical ablation and laser photocoagulation can be monitored by temperature-sensitive MR imaging). Another potential application is to use the information of the location and orientation of the device in order to enable display of the MRI images in reference to the device local coordinate system, as if the operator is looking through the device and in the direction of the tip, similar to the use of optical endoscopes. One more application is to use the location tracking in order to mark location of previous interventions on the MRI image.

An application with great clinical importance, where using MRI guidance is of specific advantage, is percutaneous myocardial revascularization (PMR). PMR is typically performed during cardiac catheterization. A laser transmitting catheter is inserted through the femoral artery up through the aorta into the left ventricle of the heart. Based on prior perfusion studies (e.g. Thallium scan) or indirect information on viability of the myocardium (e.g. by measurement of local wall motion), the cardiologist applies laser energy to drill miniature channels in the inner portion of the heart muscle, which stimulates angiogenesis and new blood vessel growth. PMR potentially provides a less invasive solution (compared to bypass surgery) for ischemic heart disease patients which cannot be adequately managed by angioplasty or stent placement. It may also be used in conjunction with angioplasty or stents to treat areas of the heart not completely revascularized by a balloon or stent placement. Currently, PMR is exclusively done with X-ray guidance. The main advantage of MRI is the excellent performance of MRI in the assessment of myocardial blood perfusion, through the use of contrast agents. Thus rather than using indirect information on the location of poorly perfused regions, a diagnostic session of myocardial perfusion in the MRI scanner can be followed by immediate intervention, using the existing perfusion images and real-time tracking of the laser catheter with the disclosed tracking methodology. Additional advantage, unique to MRI, is the potential to control the intervention by high-resolution, real-time imaging of the myocardium during the application of the laser treatment. Furthermore, since PMR is typically performed on multiple locations, and a good coverage of the treated myocardium should be achieved, marking the location of the treated locations on the perfusion image, using the location data of the tracking system, may provide optimal coverage of the diseased region.

Anatomically, the tracking sensor can be used for various diagnostic and interventional procedures inside the brain (internally through blood vessels or through burr holes in the scull), the cardiovascular system (heart chambers, coronary arteries, blood vessels), the gastro-intestinal tract (stomach, duodenum, biliary tract, gall bladder, intestine, colon) and the liver, the urinary system (bladder, ureters, kidneys), the pulmonary system (the bronchial tree or blood vessels), the skeletal system (joints), the reproductive tract, and others.

**TABLE 1**

Induced voltages in 3 orthogonal coils were simulated for a sample location (X=20.5 cm, Y=10.5 cm, Z=15.0 cm) inside an MRI scanner during the activation of three gradients and are presented in the lower section of the table as voltage vectors (Vx, Vy, Vz). Using only the absolute amplitudes of the voltage vectors (|Vx|, |Vy|, |Vz|) results with eight different solutions (Xest, Yest, Zest). The use of the angles between the voltage vectors (XZ_ang, YZ_ang, YX_ang) eliminates 6 of the solutions and provides two anti-symmetric equivalent solutions (1 and 8). Finally, when the three components of each of the three voltage vectors are used (Vx, Vy, Vz), a unique correct solution (solution 8) is obtained.

|  | *Solution 1* | *Solution 2* | *Solution 3* | *Solution 4* | *Solution 5* | *Solution 6* | *Solution 7* | *Solution 8* |
|---|---|---|---|---|---|---|---|---|
| *Xest* | **-20.50** | 20.50 | -20.50 | 20.50 | -20.50 | 20.50 | -20.50 | **20.50** |
| *Yest* | **-10.50** | -10.50 | 10.50 | 10.50 | -10.50 | -10.50 | 10.50 | **10.50** |
| *Zest* | **-15.00** | -15.00 | -15.00 | -15.00 | 15.00 | 15.00 | 15.00 | **15.00** |
|  |  |  |  |  |  |  |  |  |
| *\|Vx\|* | **27.7918** | 27.7918 | 27.7918 | 27.7918 | 27.7918 | 27.7918 | 27.7918 | **27.7918** |
|  |  |  |  |  |  |  |  |  |
| *\|Vy\|* | **19.6513** | 19.6513 | 19.6513 | 19.6513 | 19.6513 | 19.6513 | 19.6513 | **19.6513** |
|  |  |  |  |  |  |  |  |  |
| *\|Vz\|* | **19.8370** | 19.8370 | 19.8370 | 19.8370 | 19.8370 | 19.8370 | 19.8370 | **19.8370** |
|  |  |  |  |  |  |  |  |  |
| *XZ_ang* | **9.7436** | -7.6928 | 7.6928 | -9.7436 | -9.7436 | 7.6928 | -7.6928 | **9.7436** |
|  |  |  |  |  |  |  |  |  |
| *YZ_ang* | **-11.1176** | -5.3237 | 5.3237 | 11.1176 | 11.1176 | 5.3237 | -5.3237 | **-11.1176** |
|  |  |  |  |  |  |  |  |  |
| *YX_ang* | **-13.0904** | 26.7508 | 26.7508 | -13.0904 | -13.0904 | 26.7508 | 26.7508 | **-13.0904** |
|  |  |  |  |  |  |  |  |  |
| *Vx* | **-16.2143** | -16.2143 | -16.2143 | -16.2143 | 16.2143 | 16.2143 | 16.2143 | **16.2143** |
|  | **-21.2103** | 17.2907 | -21.2103 | 17.2907 | -17.2907 | 21.2103 | -17.2907 | **21.2103** |

(continued)

Induced voltages in 3 orthogonal coils were simulated for a sample location (X=20.5 cm, Y=10.5 cm, Z=15.0 cm) inside an MRI scanner during the activation of three gradients and are presented in the lower section of the table as voltage vectors (Vx, Vy, Vz). Using only the absolute amplitudes of the voltage vectors (|Vx|, |Vy|, |Vz|) results with eight different solutions (Xest, Yest, Zest). The use of the angles between the voltage vectors (XZ_ang, YZ_ang, YX_ang) eliminates 6 of the solutions and provides two anti-symmetric equivalent solutions (1 and 8). Finally, when the three components of each of the three voltage vectors are used (Vx, Vy, Vz), a unique correct solution (solution 8) is obtained.

|  | Solution 1 | Solution 2 | Solution 3 | Solution 4 | Solution 5 | Solution 6 | Solution 7 | Solution 8 |
|---|---|---|---|---|---|---|---|---|
|  | **7.7202** | 14.5090 | 7.7202 | 14.5090 | -14.5090 | -7.7202 | -14.5090 | **-7.7202** |
|  |  |  |  |  |  |  |  |  |
| *Vy* | **-12.2805** | -12.2805 | -12.2805 | -12.2805 | 12.2805 | 12.2805 | 12.2805 | **12.2805** |
|  | **11.6284** | 11.6284 | -7.5044 | -7.5044 | 7.5044 | 7.5044 | -11.6284 | **-11.6284** |
|  | **-10.0072** | -10.0072 | -13.3808 | -13.3808 | 13.3808 | 13.3808 | 10.0072 | **10.0072** |
|  |  |  |  |  |  |  |  |  |
| *Vz* | **4.9383** | -12.0771 | 12.0771 | -4.9383 | 4.9383 | -12.0771 | 12.0771 | **-4.9383** |
|  | **-13.2568** | -15.7361 | -14.7342 | -17.2135 | 17.2135 | 14.7342 | 15.7361 | **13.2568** |
|  | **-13.9060** | 0.1548 | -5.5275 | 8.5332 | -8.5332 | 5.5275 | -0.1548 | **13.9060** |

**Claims**

1.  A method of determining the instantaneous location and orientation of an object (30) moving through a three-dimensional space within the imaging space of a magnetic resonance imaging apparatus (40) during operation of said magnetic resonance imaging apparatus, **characterized in that** the method comprises:

    - providing a coil assembly (20) including a plurality of at least three sensor coils (22, 24, 26) having axes of known orientation with respect to each other, said axes being mutually orthogonal with respect to one another, the coil assembly (20) being attached to or integrated into said object (30),
    - measuring the instantaneous values of electrical potentials (700) induced in said plurality of sensor coils (22, 24, 26) by the activation of the gradient coils (43) of said magnetic resonance imaging apparatus (40) during operation of said magnetic resonance imaging apparatus (40); and
    - computing the instantaneous location and orientation of said object (30) within said space by comparing said measured instantaneous values of electrical potentials (700) with the known three dimensional maps of the magnitude and the direction of the magnetic fields generated within said imaging space by said activation of the gradient coils (43), said step of comparing making use of the known relative orientation of said plurality of sensor coils (22, 24, 26).

2.  The method of claim 1, **characterized in that** said step of measuring further includes the step of identifying a plurality of activations (712) of the magnetic gradient fields of said magnetic resonance imaging apparatus (40), wherein said step of identifying provides the timing and the amplitude of activations of a single gradient coil (43) or combined activations of two or three gradient coils (43) of said magnetic resonance imaging apparatus (40); and **in that** said step of computing comprises:

    i. calculating voltage vector for each said sensor coil (22, 24, 26) with magnitude equals to said induced electrical potentials (700) generated in said sensor coil (22, 24, 26) and direction defined by unit vector vertical to the plane of said sensor coil (22, 24, 26);
    ii. calculating voltage sum vector by vectorial summation of said voltage vectors in different sensor coils for each said activation of the gradient fields of the MRI scanner;
    iii. calculating (716) the magnitudes of all said voltage sum vectors and the angles between all possible pairs of said voltage sum vectors;
    iv. storing in memory the reference magnetic field maps of each of the three gradient coils (43) of said magnetic resonance imaging apparatus (40) for the imaging space of said magnetic resonance imaging apparatus (40);

v. estimating the location of the sensor by applying (718) a search algorithm that compares said calculated magnitudes and angles of said voltage sum vectors to the known reference magnetic field maps and the known reference 3

magnetic field maps using the known relative orientation of the sensor coils (22, 24, 26) in said coil assembly; and

vi. estimating the orientation of the sensor (20) by an iterative optimization procedure in order to determine the three rotation angles which transform, at the location of the device estimated in step (v), from a local, object-attached coordinate system to the MRI reference coordinate system defined by said gradient coils, wherein said step of estimating the orientation involves

processing (720) said induced electrical potentials (700) generated in said sensor coils (22, 24, 26) together with the known reference magnetic field maps and the known relative orientation of the sensor coils (22, 24, 26) in said coil assembly.

3. The method according to claim 1, **characterized in that** said coil assembly includes three pairs of sensor coils (22-27), in which one sensor coil (22-27) in each pair has the same orientation as the other sensor coil (22-27) in the respective pair, and in which each pair of sensor coils (22-27) has a different orientation from the other pairs of sensor coils (22-27).

4. The method according to claim 1, **characterized in that** said coil assembly includes a cylindrical sensor coil and two pairs of sensor coils oriented orthogonally with respect to each other and positioned orthogonally with respect to the cylindrical sensor coil.

5. The method according to Claim 1, **characterized in that** said object (30) is a medical instrument moving in the body of a person for medical diagnostic or treatment purposes.

6. Apparatus for determining the instantaneous location and orientation of an object (30) moving through a three-dimensional space within the imaging space of q magnetic resonance imaging apparatus (40) during operation of said magnetic resonance imaging apparatus (40), **characterized in** comprising:

a coil assembly (20) including a plurality of at least three sensor coils (22, 24, 26) having axes of known orientation with respect to each other, said axes being mutually orthogonal with respect to one another, the coil assembly (20) being attached to or integrated into said object (30),

means for measuring the instantaneous values of electrical potentials (700) induced in said plurality of sensor coils (22, 24, 26) by the activation of the gradient coils (43) of said magnetic resonance imaging apparatus (40) during operation of said magnetic resonance imaging apparatus (40); and

a processor (10) for computing the instantaneous location and orientation of said object (30) within said space by comparing said measured instantaneous values of electrical potentials (700) with the known three dimensional maps of the magnitude and the direction of the magnetic fields generated within said imaging space by said activation of the gradient coils (43), said comparing making use of the known relative orientation of said plurality of sensor coils (22, 24, 26).

7. The apparatus of claim 6, **characterized in that** said measuring means further includes means for identifying a plurality of activations of the magnetic gradient fields of said magnetic resonance imaging apparatus (40), wherein said means for identifying provides the timing and the amplitude of activations of a single gradient coil or combined activations of two or three gradient coils (43) of said magnetic resonance imaging apparatus (40); and **in that** said processor (10) further comprises :

i. means for calculating voltage vector for each said sensor coil (22, 24, 26) with magnitude equals to said induced electrical potentials generated in said sensor coil (22, 24, 26) and direction defined by unit vector vertical to the plane of said sensor coil (22, 24, 26);

ii. means for calculating voltage sum vector by vectorial summation of said voltage vectors in different sensor coils (22, 24, 26) for each said activation of the gradient fields of the MRI scanner;

iii. means for calculating the magnitudes of all said voltage sum vectors and the angles between all possible pairs of said voltage sum vectors;

iv. memory for storing the reference magnetic field maps of each of the three gradient coils (43) of said magnetic resonance imaging apparatus (40) for the imaging space of said magnetic resonance imaging apparatus (40);

v. means for estimating the location of the sensor (20) by applying a search algorithm that compares said calculated magnitudes and angles of said voltage sum vectors to the known reference magnetic field maps and the known reference angular field maps, using the known relative orientation of the sensor coils (22,24,26) in said coil assembly; and

vi. means for estimating the orientation of the sensor (20) by an iterative optimization procedure in order to determine the three rotation angles which transform, at the location of the device estimated by said means for estimating the location of the sensor, from a local, object-attached coordinate system to the MRI reference coordinate system defined by said gradient coils by processing said induced electrical potentials generated in said sensor coils (22,24,26) together with the known reference magnetic maps and the known relative orientation of the sensor coils (22,24,26) in said coil assembly.

8.  The apparatus according to claim 6, **characterized in that** said coil assembly (20) includes three pairs of sensor coils (22-27), in which one sensor coil in each pair has the same orientation as the other sensor coil (22-27) in the respective pair, and in which each pair of sensor coils (22-27) has a different orientation from the other pairs of sensor coils (22-27).

9.  The apparatus according to claim 6, **characterized in that** said coil assembly includes a cylindrical sensor coil and two pairs of sensor coils oriented orthogonally with respect to each other and positioned orthogonally with respect to the cylindrical sensor coil.

10. The apparatus according to claim 6, **characterized in that** said object (30) is a medical instrument moving in the body of a person for medical diagnostic or treatment purposes, and wherein said sensor (20) is adhered to, or integrated into, said medical instrument.

**Patentansprüche**

1.  Verfahren zur Ermittlung des momentanen Standortes und der momentanen Orientierung eines Objekts (30), das sich durch einen dreidimensionalen Raum bewegt, innerhalb des Bildgebungsraums einer Magnetresonanzbildgebungsvorrichtung (40) während des Betriebs der Magnetresonanzbildgebungsvorrichtung, **dadurch gekennzeichnet, dass** das Verfahren umfasst:

    - Vorsehen einer Spulenanordnung (20), welche eine Vielzahl von mindestens drei Sensorspulen (22, 24, 26) beinhaltet, die Achsen von bekannter Orientierung bezüglich einander aufweisen, wobei die Achsen bezüglich einander orthogonal zueinander sind, wobei die Spulenanordnung (20) an dem Objekt (30) befestigt oder in dieses integriert ist,
    - Messen der momentanen Werte elektrischer Potentiale (700), die durch die Aktivierung der Gradientenspulen (43) der Magnetresonanzbildgebungsvorrichtung (40) während des Betriebs der Magnetresonanzbildgebungsvorrichtung (40) in der Vielzahl von Sensorspulen (22, 24, 26) induziert werden; und
    - Errechnen des momentanen Standorts und der momentanen Orientierung des Objekts (30) innerhalb besagten Raums durch Vergleichen der gemessenen momentanen Werte elektrischer Potentiale (700) mit den bekannten dreidimensionalen Karten der Größenordnung und der Richtung der innerhalb des Bildgebungsraums durch die Aktivierung der Gradientenspulen (43) erzeugten Magnetfelder, wobei der Schritt des Vergleichens von der bekannten relativen Orientierung der Vielzahl von Sensorspulen (22, 24, 26) Gebrauch macht.

2.  Verfahren nach Anspruch 1, **dadurch gekennzeichnet, dass** der Schritt des Messens weiter den Schritt des Identifizierens einer Vielzahl von Aktivierungen (712) der Magnetgradientenfelder der Magnetresonanzbildgebungsvorrichtung (40) beinhaltet, wobei der Schritt des Identifizierens die Zeitvorgabe und die Amplitude von Aktivierungen einer einzigen Gradientenspule (43) oder kombinierte Aktivierungen von zwei oder drei Gradientenspulen (43) der Magnetresonanzbildgebungsvorrichtung (40) vorsieht; und dass der Schritt des Errechnens umfasst:

    i. Berechnen des Spannungsvektors für jede Sensorspule (22, 24, 26) mit Größenordnungen gleich den induzierten elektrischen Potentialen (700), die in der Sensorspule (22, 24, 26) erzeugt wurden, und der Richtung, definiert durch den Einheitenvektor vertikal zur Ebene der Sensorspule (22, 24, 26);
    ii. Berechnen des Spannungssummenvektors durch vektorielle Summierung der Spannungsvektoren in verschiedenen Sensorspulen für jede Aktivierung der Gradientenfelder des MRT-Scanners;
    iii. Berechnen (716) der Größenordnungen aller Spannungssummenvektoren und der Winkel zwischen allen möglichen Paaren der Spannungssummenvektoren;
    iv. im Speicher Speichern der Magnetfeld-Referenzkarten jeder der drei Gradientenspulen (43) der Magnetresonanzbildgebungsvorrichtung (40) für den Bildgebungsraum der Magnetresonanzbildgebungsvorrichtung (40);

v. Abschätzen des Standortes des Sensors durch Anwenden (718) eines Suchalgorithmus, der die berechneten Größenordnungen und Winkel der Spannungssummenvektoren mit den bekannten Magnetfeld-Referenzkarten und den bekannten Winkelfeld-Referenzkarten vergleicht, unter Anwendung der bekannten relativen Orientierung der Sensorspulen (22, 24, 26) in der Spulenanordnung; und

vi. Abschätzen der Orientierung des Sensors (20) durch eine iterative Optimierungsprozedur, um die drei Rotationswinkel zu ermitteln, die sich an dem in Schritt (v) abgeschätzten Standort der Vorrichtung, von einem örtlichen, objektgebundenen Koordinatensystem zu dem durch die Gradientenspulen definierten MRT-Referenzkoordinatensystem umwandeln,

wobei der Schritt des Abschätzens der Orientierung das Verarbeiten (720) der in den Sensorspulen (22, 24, 26) erzeugten, induzierten elektrischen Potentiale (700) zusammen mit den bekannten Magnetfeld-Referenzkarten und der bekannten relativen Orientierung der Sensorspulen (22, 24, 26) in der Spulenanordnung einbezieht.

3. Verfahren nach Anspruch 1, **dadurch gekennzeichnet, dass** die Spulenanordnung drei Paare von Sensorspulen (22-27) beinhaltet, wobei eine Sensorspule (22-27) in jedem Paar die gleiche Orientierung wie die andere Sensorspule (22-27) in dem betreffenden Paar hat, und wobei jedes Paar von Sensorspulen (22-27) eine von den anderen Paaren von Sensorspulen (22-27) verschiedene Orientierung aufweist.

4. Verfahren nach Anspruch 1, **dadurch gekennzeichnet, dass** die Spulenanordnung eine zylindrische Sensorspule und zwei Paare von Sensorspulen, die orthogonal bezüglich einander orientiert und orthogonal bezüglich der zylindrischen Sensorspule positioniert sind, beinhaltet.

5. Verfahren nach Anspruch 1, **dadurch gekennzeichnet, dass** das Objekt (30) ein medizinisches Instrument ist, das sich zu medizinischen Diagnose- oder Behandlungszwecken im Körper einer Person bewegt.

6. Vorrichtung zur Ermittlung des momentanen Standortes und der momentanen Orientierung eines Objekts (30), das sich durch einen dreidimensionalen Raum bewegt, innerhalb des Bildgebungsraums einer Magnetresonanzbildgebungsvorrichtung (40) während des Betriebs der Magnetresonanzbildgebungsvorrichtung, **dadurch gekennzeichnet, dass** sie umfasst:

   - eine Spulenanordnung (20), welche eine Vielzahl von mindestens drei Sensorspulen (22, 24, 26) umfasst, die Achsen von bekannter Orientierung bezüglich einander aufweisen, wobei die Achsen bezüglich einander orthogonal zueinander sind, wobei die Spulenanordnung (20) an dem Objekt (30) befestigt oder in dieses integriert ist,
   - Mittel zum Messen der momentanen Werte elektrischer Potentiale (700), die durch die Aktivierung der Gradientenspulen (43) der Magnetresonanzbildgebungsvorrichtung (40) während des Betriebs der Magnetresonanzbildgebungsvorrichtung (40) in der Vielzahl von Sensorspulen (22, 24, 26) induziert werden; und
   - einen Prozessor (10) zum Errechnen des momentanen Standorts und der momentanen Orientierung des Objekts (30) innerhalb besagten Raums durch Vergleichen der gemessenen momentanen Werte elektrischer Potentiale (700) mit den bekannten dreidimensionalen Karten der Größenordnung und der Richtung der innerhalb des Bildgebungsraums durch die Aktivierung der Gradientenspulen (43) erzeugten Magnetfelder, wobei das Vergleichen von der bekannten relativen Orientierung der Vielzahl von Sensorspulen (22, 24, 26) Gebrauch macht.

7. Vorrichtung nach Anspruch 6, **dadurch gekennzeichnet, dass** das Messmittel weiter Mittel zur Identifizierung einer Vielzahl von Aktivierungen der Magnetgradientenfelder der Magnetresonanzbildgebungsvorrichtung (40) beinhaltet, wobei das Mittel zur Identifizierung die Zeitvorgabe und die Amplitude von Aktivierungen einer einzigen Gradientenspule oder kombinierte Aktivierungen von zwei oder drei Gradientenspulen (43) der Magnetresonanzbildgebungsvorrichtung (40) vorsieht; und dass der Prozessor (10) weiter umfasst:

   i. Mittel zum Berechnen des Spannungsvektors für jede Sensorspule (22, 24, 26) mit Größenordnungen gleich den induzierten elektrischen Potentialen, die in der Sensorspule (22, 24, 26) erzeugt wurden, und der Richtung, definiert durch den Einheitenvektor vertikal zur Ebene der Sensorspule (22, 24, 26);
   ii. Mittel zum Berechnen des Spannungssummenvektors durch vektorielle Summierung der Spannungsvektoren in verschiedenen Sensorspulen (22, 24, 26) für jede Aktivierung der Gradientenfelder des MRT-Scanners;
   iii. Mittel zum Berechnen der Größenordnungen aller Spannungssummenvektoren und der Winkel zwischen allen möglichen Paaren der Spannungssummenvektoren;
   iv. Speicher zum Speichern der Magnetfeld-Referenzkarten jeder der drei Gradientenspulen (43) der Magnetresonanzbildgebungsvorrichtung (40) für den Bildgebungsraum der Magnetresonanzbildgebungsvorrichtung (40);

v. Mittel zum Abschätzen des Standortes des Sensors (20) durch Anwenden eines Suchalgorithmus, der die berechneten Größenordnungen und Winkel der Spannungssummenvektoren mit den bekannten Magnetfeld-Referenzkarten und den bekannten Winkelfeld-Referenzkarten vergleicht, unter Anwendung der bekannten relativen Orientierung der Sensorspulen (22, 24, 26) in der Spulenanordnung; und

vi. Mittel zum Abschätzen der Orientierung des Sensors (20) durch eine iterative Optimierungsprozedur, um die drei Rotationswinkel zu ermitteln, die sich, an dem von den Mitteln zum Abschätzen des Standortes des Sensors abgeschätzten Standort der Vorrichtung, von einem örtlichen, objektgebundenen Koordinatensystem zu dem durch die Gradientenspulen definierten MRT-Referenzkoordinatensystem umwandeln, durch Verarbeiten der in den Sensorspulen (22, 24, 26) erzeugten, induzierten elektrischen Potentiale zusammen mit den bekannten Magnet-Referenzkarten und der bekannten relativen Orientierung der Sensorspulen (22, 24, 26) in der Spulenanordnung.

**8.** Vorrichtung nach Anspruch 6, **dadurch gekennzeichnet, dass** die Spulenanordnung (20) drei Paare von Sensorspulen (22-27) beinhaltet, wobei eine Sensorspule in jedem Paar die gleiche Orientierung wie die andere Sensorspule (22-27) in dem betreffenden Paar aufweist, und wobei jedes Paar von Sensorspulen (22-27) eine von den anderen Paaren von Sensorspulen (22-27) verschiedene Orientierung aufweist.

**9.** Vorrichtung nach Anspruch 6, **dadurch gekennzeichnet, dass** die Spulenanordnung eine zylindrische Sensorspule und zwei Paare von Sensorspulen, die orthogonal bezüglich einander orientiert und orthogonal bezüglich der zylindrischen Sensorspule positioniert sind, beinhaltet.

**10.** Vorrichtung nach Anspruch 6, **dadurch gekennzeichnet, dass** das Objekt (30) ein medizinisches Instrument ist, das sich zu medizinischen Diagnose- oder Behandlungszwecken im Körper einer Person bewegt, und wobei der Sensor (20) an dem medizinischen Instrument befestigt oder in dieses integriert ist.

## Revendications

**1.** Procédé pour la détermination de l'emplacement et de l'orientation instantanés d'un objet (30) se déplaçant à travers un espace tridimensionnel au sein de l'espace de formation d'image d'un appareil d'imagerie par résonance magnétique (40) lors de la mise en service dudit appareil d'imagerie par résonance magnétique, **caractérisé en ce que** le procédé comprend le fait de :

- procurer un assemblage de bobines (20) englobant un nombre d'au moins trois bobines de détection (22, 24, 26) possédant des axes d'orientation connue les uns par rapport aux autres, lesdits axes étant mutuellement perpendiculaires les uns par rapport aux autres, l'assemblage de bobines (20) étant fixé audit objet (30) ou intégré dans celui-ci ;

- mesurer les valeurs instantanées de potentiels électriques (700) induits dans lesdites plusieurs bobines de détection (22, 24, 26) par l'activation des bobines de gradient (43) dudit appareil d'imagerie par résonance magnétique (40) lors de la mise en service dudit appareil d'imagerie par résonance magnétique (40) ; et

- calculer l'emplacement et l'orientation instantanés dudit objet (30) au sein dudit espace en comparant lesdites valeurs instantanées mesurées des potentiels électriques (700) aux cartes connues en trois dimensions de la magnitude et de la direction des champs magnétiques générés au sein dudit espace de formation d'image par ladite activation des bobines de gradient (43), ladite étape de comparaison faisant usage de l'orientation relative connue desdites plusieurs bobines de détection (22, 24, 26).

**2.** Procédé selon la revendication 1, **caractérisé en ce que** ladite étape de mesure englobe en outre l'étape consistant à identifier plusieurs activations (712) des champs magnétiques à gradient dudit appareil d'imagerie par résonance magnétique (40), ladite étape d'identification fournissant la synchronisation et l'amplitude des activations d'une seule bobine de gradient (43) ou des activations combinées de deux ou trois bobines de gradient (43) dudit appareil d'imagerie par résonance magnétique (40) ; et **en ce que** ladite étape de calcul comprend le fait de :

i. calculer le vecteur de tension pour chacune desdites bobines de détection (22, 24, 26), la magnitude étant égale auxdits potentiels électriques induits (700) générés dans ladite bobine de détection (22, 24, 26), et la direction étant définie par un vecteur unitaire en position verticale par rapport au plan de ladite bobine de détection (22, 24, 26) ;

ii. calculer le vecteur de la somme des tensions par l'addition vectorielle desdits vecteurs de tensions dans différentes bobines de détection pour chacune desdites activations des champs à gradient du dispositif de balayage IRM ;

iii. calculer (716) les magnitudes de l'ensemble desdits vecteurs des sommes de tensions et les angles entre toutes les paires possibles desdits vecteurs des sommes de tensions ;

iv. mettre en mémoire les cartes de référence des champs magnétiques de chacune des trois bobines de gradient (43) dudit appareil d'imagerie par résonance magnétique (40) pour l'espace de formation d'image dudit appareil d'imagerie par résonance magnétique (40) ;

v. estimer l'emplacement du capteur en appliquant (718) un algorithme de recherche qui compare lesdites magnitudes et lesdits angles calculés desdits vecteurs des sommes de tensions aux cartes de référence connues des champs magnétiques et aux cartes de référence connues des champs angulaires en utilisant l'orientation relative connue des bobines de détection (22, 24, 26) dans ledit assemblage de bobines ; et

vi. estimer l'orientation du capteur (20) via un procédé d'optimisation itérative dans le but de déterminer les trois angles de rotation qui se transforment, à l'emplacement du dispositif estimé à l'étape (v), par rapport à un système de coordonnées local attaché à l'objet, compte tenu du système de coordonnées de référence IRM défini par lesdites bobines de gradient ;

ladite étape d'estimation de l'orientation implique le traitement (720) desdits potentiels électriques induits (700) générés dans lesdites bobines de détection (22, 24, 26) conjointement avec les cartes de référence connues des champs magnétiques et l'orientation relative connue des bobines de détection (22, 24, 26) dans ledit assemblage de bobines.

3. Procédé selon la revendication 1, **caractérisé en ce que** ledit assemblage de bobines englobe trois paires de bobines de détection (22-27), une bobine de détection (22-27) dans chaque paire ayant la même orientation que celle de l'autre bobine de détection (22-27) dans la paire respective, et chaque paire de bobines de détection (22-27) possédant une orientation différente de celle des autres paires de bobines de détection (22-27).

4. Procédé selon la revendication 1, **caractérisé en ce que** ledit assemblage de bobines englobe une bobine de détection cylindrique et deux paires de bobines de détection orientées perpendiculairement l'une par rapport à l'autre et disposées perpendiculairement par rapport à la bobine de détection cylindrique.

5. Procédé selon la revendication 1, **caractérisé en ce que** ledit objet (30) est un instrument médical qui se déplace dans le corps d'une personne à des fins de traitement ou de diagnostic médical.

6. Appareil pour la détermination de l'emplacement et de l'orientation instantanés d'un objet (30) se déplaçant à travers un espace tridimensionnel au sein de l'espace de formation d'image d'un appareil d'imagerie par résonance magnétique (40) lors de la mise en service dudit appareil d'imagerie par résonance magnétique, **caractérisé en ce qu'**il comprend :

    - un assemblage de bobines (20) englobant un nombre d'au moins trois bobines de détection (22, 24, 26) possédant des axes d'orientation connue les uns par rapport aux autres, lesdits axes étant mutuellement perpendiculaires les uns par rapport aux autres, l'assemblage de bobines (20) étant fixé audit objet (30) ou intégré dans celui-ci ;
    - un moyen pour mesurer les valeurs instantanées de potentiels électriques (700) induits dans lesdites plusieurs bobines de détection (22, 24, 26) par l'activation des bobines de gradient (43) dudit appareil d'imagerie par résonance magnétique (40) lors de la mise en service dudit appareil d'imagerie par résonance magnétique (40) ; et
    - un processeur (10) pour calculer l'emplacement et l'orientation instantanés dudit objet (30) au sein dudit espace en comparant lesdites valeurs instantanées mesurées des potentiels électriques (700) aux cartes connues en trois dimensions de la magnitude et de la direction des champs magnétiques générés au sein dudit espace de formation d'image par ladite activation des bobines de gradient (43), ladite comparaison faisant usage de l'orientation relative connue desdites plusieurs bobines de détection (22, 24, 26).

7. Appareil selon la revendication 6, **caractérisé en ce que** ledit moyen de mesure englobe en outre un moyen pour identifier plusieurs activations des champs magnétiques à gradient dudit appareil d'imagerie par résonance magnétique (40), ledit moyen d'identification fournissant la synchronisation et l'amplitude des activations d'une seule bobine de gradient (43) ou des activations combinées de deux ou trois bobines de gradient (43) dudit appareil d'imagerie par résonance magnétique (40) ; et **en ce que** ledit processeur (10) comprend en outre :

    i. un moyen pour calculer le vecteur de tension pour chacune desdites bobines de détection (22, 24, 26), la magnitude étant égale auxdits potentiels électriques induits générés dans ladite bobine de détection (22, 24, 26), et la direction étant définie par un vecteur unitaire en position verticale par rapport au plan de ladite bobine de détection (22, 24, 26) ;

ii. un moyen pour calculer le vecteur de la somme des tensions par l'addition vectorielle desdits vecteurs de tensions dans différentes bobines de détection pour chacune desdites activations des champs à gradient du dispositif de balayage IRM ;

iii. un moyen pour calculer les magnitudes de l'ensemble desdits vecteurs des sommes de tensions et les angles entre toutes les paires possibles desdits vecteurs des sommes de tensions ;

iv. une mémoire pour stocker les cartes de référence des champs magnétiques de chacune des trois bobines de gradient (43) dudit appareil d'imagerie par résonance magnétique (40) pour l'espace de formation d'image dudit appareil d'imagerie par résonance magnétique (40) ;

v. un moyen pour estimer l'emplacement du capteur (20) en appliquant un algorithme de recherche qui compare lesdites magnitudes et lesdits angles calculés desdits vecteurs des sommes de tensions aux cartes de référence connues des champs magnétiques et aux cartes de référence connues des champs angulaires en utilisant l'orientation relative connue des bobines de détection (22, 24, 26) dans ledit assemblage de bobines ; et

vi. un moyen pour estimer l'orientation du capteur (20) via un procédé d'optimisation itérative dans le but de déterminer les trois angles de rotation qui se transforment, à l'emplacement du dispositif estimé par ledit moyen d'estimation de l'emplacement du capteur, par rapport à un système de coordonnées local attaché à l'objet, compte tenu du système de coordonnées de référence IRM défini par lesdites bobines de gradient en traitant lesdits potentiels électriques induits générés dans lesdites bobines de détection (22, 24, 26) conjointement avec les cartes de référence connues des champs magnétiques et l'orientation relative connue des bobines de détection (22, 24, 26) dans ledit assemblage de bobines.

8. Appareil selon la revendication 6, **caractérisé en ce que** ledit assemblage de bobines (20) englobe trois paires de bobines de détection (22-27), une bobine de détection (22-27) dans chaque paire ayant la même orientation que celle de l'autre bobine de détection (22-27) dans la paire respective, et chaque paire de bobines de détection (22-27) possédant une orientation différente de celle des autres paires de bobines de détection (22-27).

9. Appareil selon la revendication 6, **caractérisé en ce que** ledit assemblage de bobines englobe une bobine de détection cylindrique et deux paires de bobines de détection orientées perpendiculairement l'une par rapport à l'autre et disposées perpendiculairement par rapport à la bobine de détection cylindrique.

10. Appareil selon la revendication 6, **caractérisé en ce que** ledit objet (30) est un instrument médical qui se déplace dans le corps d'une personne à des fins de traitement ou de diagnostic médical, et dans lequel ledit capteur (20) adhère audit instrument médical ou est intégré dans celui-ci.

## FIG. 1A

## FIG. 1B

# FIG. 2

**FIG. 3A**

**FIG. 3B**

**FIG. 4A**

**FIG. 4B**

Figure 5A

Figure 5B

Figure 5C

Figure 5D

# FIG. 6

| Sensor | Electronic Interface | Processing and Control Unit |
|---|---|---|

Amplifier → Low-pass filter → Notch filter → A/D Board ↔ Processor

122      124      126      102      104

20      12      10

MRI analog interface      MRI digital interface

## FIG. 7

Input: ~700
potentials in sensor coils

Input: ~702
gradient activation pattern

MRI interface

704

~710
Amplification and filteration by the electronic interface

~714
Digitize induced potentials during gradient activation

Determine gradient activation time

712

Calculate amplitudes of induced voltage-vectors and angles between the vectors

716

Estimation of the sensor location:
1. grid search to find coarse location
2. iterative search to find accurate location
3. Grid search to find the sensor orientation
4. Iterative search to find orientation

718

Estimation of the sensor orientation:
1. using the estimated location find gradient fields at the sensor location
2. grid search to find coarse orientation
3. iterative seach to find accurate orientation

720

Enhancement of the tracking:
1. additional iteration for combined estimation of location and orientation.
2. smoothing of estimation results

722

Output:
location and orientation data to the MRI scanner

724

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 9404938 A
- US 5558091 A, Acker
- US 5042486 A, Pfeiler
- US 5391199 A
- US 5318025 A
- WO 9404938 A1

**Non-patent literature cited in the description**

- **Nitin Patel ; David Sandeman.** A Simple Trajectory Guidance Device that Assists Freehand and Interactive Image Guided Biopsy of Small Deep Intracranial Targets. *Comp Aid Surg,* 1997, vol. 2, 186-192
- Magnetic resonance tracking. **Dumoulin CL ; Darro RD ; Souza SP.** Interventional MR. 1998
- **Yoshimi Anzai ; Rex Hamilton ; Shantanu Sinha ; Antonio DeSalles ; Keith Black ; Robert Lufkin.** Interventional MRI for Head and Neck Cancer and Other Applications. *Advances in Oncology,* May 1995, vol. 11 (2